# EUROPEAN PATENT APPLICATION

(11) **EP 4 472 361 A1**
(43) Date of publication of application: **04.12.2024**
(21) Application number: 23747283.2
(22) Date of filing: 20.01.2023
(51) Int. Cl.: H05K 1/16, H05K 1/09, H01C 7/00, H01M 10/60

(54) **BATTERY PACK PRINTED CIRCUIT BOARD CAPABLE OF MEASURING TEMPERATURE, AND MANUFACTURING METHOD THEREFOR**

(30) Priority: 28.01.2022 KR 20220013746
(71) Applicant: LG Energy Solution, Ltd., Seoul 07335 (KR)
(72) Inventor: SEON, Sang Ok, Daejeon 34122 (KR)
(74) Representative: Goddar, Heinz J.
(86) International application number: PCT/KR2023/001066
(87) International publication number: WO 2023/146242

(57) **Abstract**

The present invention relates to a printed circuit board for a battery pack capable of measuring temperature and a method for manufacturing same. The printed circuit board for a battery pack according to the present invention, capable of measuring temperature and provided in a battery pack including a plurality of secondary batteries, includes: a film; a conductive pattern provided on a first portion of the film; and a temperature element provided on a second portion of the film and measuring the temperature inside the battery pack.

## Description

### TECHNICAL FIELD

### CROSS-REFERENCE TO RELATED APPLICATION

The present application claims the benefit of the priority of Korean Patent Application No. 2022-0013746, filed on January 28, 2022, which is hereby incorporated by reference in its entirety.

### TECHNICAL FIELD

The present invention relates to a printed circuit board for a battery pack capable of measuring temperature and a method for manufacturing same.

### BACKGROUND ART

Secondary batteries, unlike primary batteries, can be recharged and have been extensively researched and developed in recent years due to small sizes and high capacities thereof. As technology development and demands for mobile devices increase, the demands for secondary batteries as energy sources are rapidly increasing.

Secondary batteries are classified into coin-type batteries, cylindrical batteries, prismatic batteries, and pouch-type batteries depending on shapes of battery cases. In such a secondary battery, an electrode assembly installed inside a battery case serves as a chargeable and dischargeable power generating element that has a structure in which electrodes and separators are stacked.

The secondary batteries are attracting much attention as energy sources for power devices, such as electric bicycles, electric vehicles, and hybrid electric vehicles, as well as mobile devices, such as mobile phones, digital cameras, and laptop computers.

A small-sized battery pack, in which one battery cell is packed, is used in small devices, such as mobile phones and cameras. However, a medium- or large-sized battery pack, in which two or more battery cells connected in parallel and/or in series are packed, is used in medium- or large-sized devices, such as laptop computers and electric vehicles. Accordingly, the number of battery cells included in the battery pack may be variously set depending on required output voltages or charge/discharge capacities.

Meanwhile, when constituting a battery pack by connecting a plurality of battery cells in series/in parallel, it is common to first constitute a battery module including at least one battery cell. Subsequently, a battery pack is constituted by using the at least one battery module and adding other components. The number of battery modules included in the battery pack or the number of battery cells included in the battery module may be variously set depending on required output voltages or charge/discharge capacities. The battery module configured as described above includes a plurality of battery cells stacked on each other and a busbar electrically connecting electrode leads of the plurality of battery cells.

In order to prevent the performance of the battery pack from deteriorating, a battery temperature management system is mounted on a vehicle. In addition, sensing is required to manage the temperature of the battery pack, and a temperature sensor for the sensing is required.

### DISCLOSURE OF THE INVENTION

### TECHNICAL PROBLEM

One aspect of the present invention is to provide a printed circuit board for a battery pack, capable of measuring temperature and facilitating measuring the temperature of a battery pack, and a method for manufacturing same.

### TECHNICAL SOLUTION

An embodiment of the present invention provides a printed circuit board for a battery pack, capable of measuring temperature and provided in a battery pack that includes a plurality of secondary batteries, the printed circuit board including: a film; a conductive pattern provided on a first portion of the film; and a temperature element provided on a second portion of the film and measuring the temperature inside the battery pack.

An embodiment of the present invention provides a method for manufacturing a printed circuit board for a battery pack, capable of measuring temperature and provided in a battery pack that includes a plurality of secondary batteries, the method including: a film preparation operation of preparing a film; a conductive pattern formation operation of forming a conductive pattern on a first portion of the prepared film; and a temperature element formation operation of forming a temperature element, which measures the temperature inside the battery pack, on a second portion of the film after the conductive pattern is formed.

### ADVANTAGEOUS EFFECTS

According to the present invention, a temperature element is provided on a printed circuit board provided in a battery pack, and thus, the temperature of the battery pack may be easily measured.

### BRIEF DESCRIPTION OF THE DRAWINGS

FIG. 1 is a cross-sectional view showing a printed circuit board for a battery pack capable of measuring temperature according to an embodiment of the present invention.
FIG. 2 is an exploded perspective view showing a battery pack in which a printed circuit board for a battery pack capable of measuring temperature according to an embodiment of the present invention is utilized.
FIG. 3 is a perspective view showing main parts of a battery pack in which a printed circuit board for a battery pack capable of measuring temperature according to an embodiment of the present invention is utilized.
FIG. 4 is a front view conceptually showing a method for manufacturing a printed circuit board for a battery pack capable of measuring temperature according to an embodiment of the present invention.
FIG. 5 is a cross-sectional view showing an operation of forming a temperature element in a method for manufacturing a printed circuit board for a battery pack capable of measuring temperature according to an embodiment of the present invention.
FIG. 6 is a front view showing an operation of forming a cover layer in a method for manufacturing a printed circuit board for a battery pack capable of measuring temperature according to an embodiment of the present invention.

### MODE FOR CARRYING OUT THE INVENTION

The objects, specific advantages, and novel features of the present invention will be more clearly understood from the following detailed description and preferred embodiments taken in conjunction with the accompanying drawings. In the specification, when reference numerals are given to elements in each drawing, it should be noted that the same elements will be designated by the same reference numerals if possible although they are shown in different drawings. Also, the present invention may be embodied in various different forms, and is not limited to the embodiments described herein. In addition, in describing the present invention, detailed descriptions related to well-known functions are omitted so as not to unnecessarily obscure subject matters of the present invention.

### Printed circuit board for a battery pack capable of measuring temperature according to an embodiment of the present invention

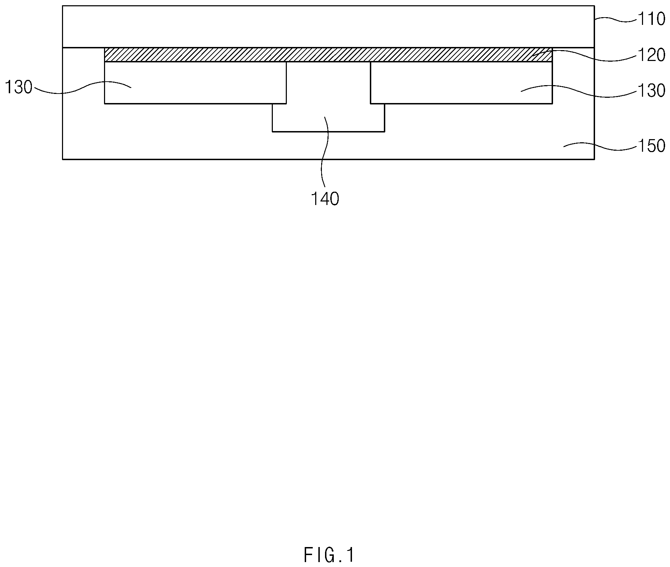

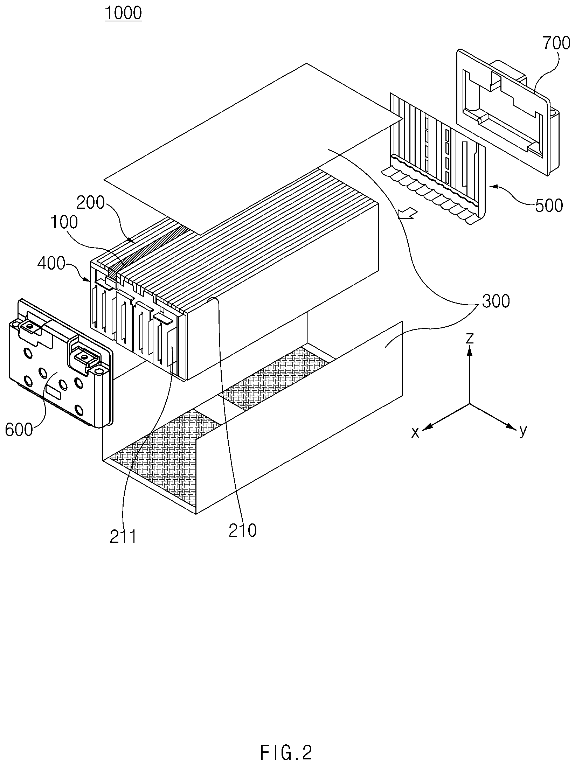

FIG. 1 is a cross-sectional view showing a printed circuit board for a battery pack capable of measuring temperature according to an embodiment of the present invention, and FIG. 2 is an exploded perspective view showing a battery pack in which a printed circuit board for a battery pack capable of measuring temperature according to an embodiment of the present invention is utilized.

Referring to FIGS. 1 and 2, a printed circuit board 100 for a battery pack capable of measuring temperature according to an embodiment of the present invention is provided in a battery pack 1000 that includes a plurality of secondary batteries 210, and the printed circuit board 100 includes a film 110, a conductive pattern 130 provided on a first portion of the film 110, and a temperature element 140 provided on a second portion of the film 110 and measuring the temperature inside the battery pack 1000. The printed circuit board 100 for a battery pack capable of measuring temperature according to an embodiment of the present invention may further include a cover layer 150 and a binder 120.

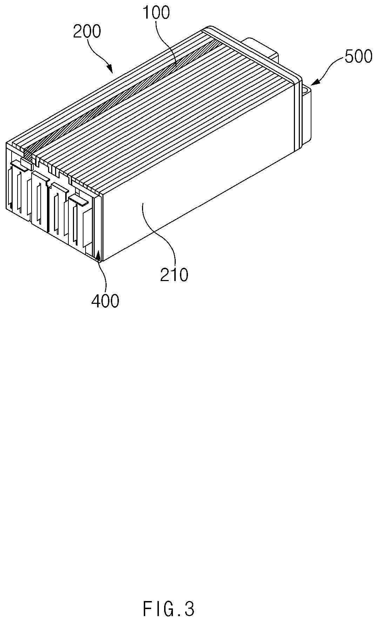

FIG. 3 is a perspective view showing main parts of a battery pack in which a printed circuit board for a battery pack capable of measuring temperature according to an embodiment of the present invention is utilized.

In more detail, referring to FIGS. 1 to 3, the battery pack 1000, in which a printed circuit board for a battery pack capable of measuring temperature according to an embodiment of the present invention is utilized, may include a cell stack 200 in which a plurality of secondary batteries 210 are stacked, busbar frames 400 and 500 which electrically connect electrode leads 20 of the plurality of secondary batteries 210 to each other, and a pack case 300 which accommodates therein the cell stack 200 and the busbar frames 400 and 500. Also, the battery pack 1000 may further include end plates 600 and 700 for covering openings on both sides of the pack case 300.

The printed circuit board for a battery pack capable of measuring temperature according to an embodiment of the present invention may include, for example, a flexible printed circuit board (FPCB) for connecting the plurality of busbar frames 400 and 500 to each other. However, the printed circuit board for a battery pack capable of measuring temperature according to an embodiment of the present invention is not necessarily limited to a printed circuit board for connecting the busbar frames 400 and 500. When used in the battery pack 1000, the printed circuit board may be applied in any place thereof.

The cell stack 200 may form a stack in which the plurality of secondary batteries 210 containing an electrolyte are stacked.

Each of the secondary batteries 210 may include an electrode assembly, an electrolyte, and a pouch that accommodates the electrode assembly and electrolyte therein.

The electrode assembly serves as a power generating element capable of charging and discharging, and may be configured by alternately stacking electrodes and separators. Here, the electrodes include positive electrodes and the negative electrodes, and thus, the positive electrodes, the separators, and the negative electrodes may be alternately stacked. Here, the separators separate and electrically insulate the positive electrodes and the negative electrodes from each other.

One side of the secondary battery 210 may be connected to an electrode of the electrode assembly, and the other side thereof may further include electrode leads 211 extending to the outside of the pouch.

The electrode leads 211 may include positive electrode leads connected to the positive electrodes and negative electrode leads connected to the negative electrodes.

Referring to FIG. 1, the film 110 may be provided in the form of a sheet.

Also, the film 110 may include an insulating material and a flexible material. Herein, the film 110 may include, for example, resin. Here, the film 110 may specifically include, for example, synthetic resin.

In addition, the film 110 may provide a substrate on which the conductive pattern 130 and the temperature element 140 are printed.

The conductive pattern 130 may be formed on the first portion of the film 110. Here, the conductive pattern 130 may be positioned on the first portion of one surface of the film 110.

In addition, the conductive pattern 130 includes an ink-type material and may be provided in the form printed on the film 110. Here, the conductive pattern 130 may be printed on the first portion of the one surface of the film 110.

Also, the conductive pattern 130 may include a silver (Ag) material.

Also, the conductive pattern 130 may include, for example, an electrically conductive circuit pattern.

The temperature element 140 is formed on the second portion of the film 110 and may measure the temperature inside the battery pack 1000. Here, the temperature element 140 may be positioned on the second portion of one surface of the film 110.

Also, the temperature element may be positioned between conductive patterns 130. Here, the temperature element may be provided in contact with the conductive patterns 130. Here, the conductive pattern 130 may be in contact with, for example, both surfaces of the temperature element.

Also, the temperature element 140 includes an ink-type material and may be provided in the form printed on the film 110. Here, the temperature element 140 may be printed on the second portion of the one surface of the film 110. Here, the temperature element 140 may form, for example, a pattern.

In addition, the temperature element may include a thermistor. The thermistor may include an element, of which an electrical resistance value varies according to temperature. Accordingly, the temperature may be measured by the resistance value of the temperature element.

Here, the temperature element may include a nickel oxide (NiO) material.

The cover layer 150 may cover both the conductive pattern 130 and the temperature element 140. Here, the cover layer 150 may be positioned on one surface of the film 110 and applied to both the conductive pattern 130 and the temperature element 140 printed on the one surface of the film 110.

In addition, the cover layer 150 may include an insulating material.

Also, the cover layer 150 may include, for example, resin.

The binder 120 may bond the conductive pattern 130 and the temperature element 140 to the film 110.

In addition, the binder 120 may be positioned between the film 110 and both the conductive pattern 130 and the temperature element 140 to form a layer.

### Method for manufacturing printed circuit board for a battery pack capable of measuring temperature according to an embodiment of the present invention

A method for manufacturing a printed circuit board for a battery pack capable of measuring temperature according to an embodiment of the present invention is described below.

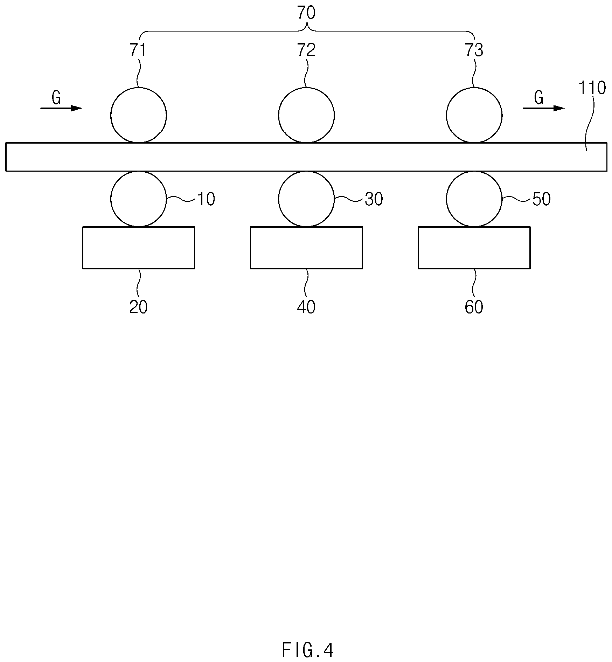

FIG. 4 is a front view conceptually showing a method for manufacturing a printed circuit board for a battery pack capable of measuring temperature according to an embodiment of the present invention.

Referring to FIGS. 1 and 4, during a secondary battery manufacturing method according to an embodiment of the present invention, provided is the method for manufacturing a printed circuit board provided in a battery pack 1000 that includes a plurality of secondary batteries 210, the method including: a film preparation operation of preparing a film 110; a conductive pattern formation operation of forming a conductive pattern 130 on a first portion of the prepared film 110; and a temperature element formation operation of forming a temperature element 140, which measures the temperature inside the battery pack 1000, on a second portion of the film 110 after the conductive pattern 130 is formed. Also, the method for manufacturing a printed circuit board for a battery pack capable of measuring temperature according to an embodiment of the present invention includes a cover layer formation operation and a binder coating operation.

The method for manufacturing a printed circuit board for a battery pack capable of measuring temperature according to an embodiment of the present invention relates to a method for manufacturing the printed circuit board 100 for a battery pack capable of measuring temperature according to the embodiment described above. Thus, this embodiment is described with a focus on differences from the above embodiment, and repeated descriptions are omitted or briefly described.

More specifically, the film 110 may be prepared during the film preparation operation. Here, the film 110 in the form of a sheet may be prepared during the film preparation operation.

Herein, the film 110 may include an insulating material and a flexible material. Herein, the film 110 may include, for example, resin. Here, the film 110 may specifically include, for example, synthetic resin.

Meanwhile, the film 110 is moved in a direction G in which the binder coating operation, the conductive pattern formation operation, the temperature element formation operation, and the cover layer formation operation are performed, and the movement thereof may be guided by guide rollers. Here, guide rollers 70 may include a first guide roller 71, a second guide roller 72, and a third guide roller 73.

Referring to FIGS. 1 and 4, the binder coating operation is performed after the film preparation operation and before the conductive pattern formation operation, and a binder 120 may be applied on the film 110 so as to bond a conductive pattern 130 and a temperature element 140 to the film 110.

Also, during the binder coating operation, the binder 120 may be positioned between the film 110 and both the conductive pattern 130 and the temperature element 140 to form a layer.

Also, during the binder coating operation, a binder ink accommodated in a binder pool 20 may be applied to one surface of the film 110 by a binder roller 10.

Meanwhile, during the binder coating operation, the other surface of the film 110 and the first guide roller 71 are in contact with each other, and the first guide roller 71 may guide the movement of the film 110. Here, the first guide roller 71 may face the binder roller 10 with the film 110 therebetween.

During the conductive pattern formation operation, the conductive pattern 130 may be formed on a first portion of the prepared film 110. Here, during the conductive pattern formation operation, the conductive pattern 130 may be positioned on the first portion of one surface of the film 110.

Also, during the conductive pattern formation operation, the conductive pattern 130 may be printed on the film 110 with conductive pattern ink. Here, the conductive pattern 130 may include a silver (Ag) material.

Also, during the conductive pattern formation operation, silver (Ag) ink accommodated in a conductive pattern pool 40 may be applied, through printing, on the first portion of the one surface of the film 110 by a conductive pattern roller 30. Here, during the conductive pattern formation operation, the silver (Ag) ink may be applied through printing, by the conductive pattern roller 30, on the first portion of the one surface of the film 110 that has been coated with the binder 120.

The conductive pattern roller 30 may have, as a roll-type print frame, a pattern frame that is formed along the outer circumferential surface and corresponds to the conductive pattern 130.

Therefore, during the conductive pattern formation operation, the conductive pattern 130 may be directly nano-printed on the film by the conductive pattern roller 30 using the silver (Ag) ink. Accordingly, the conductive pattern 130 does not protrude, and thus, it is possible to prevent a structural problem due to the protrusion. In addition, the conductive pattern 130 includes the silver (Ag) material having excellent water resistance, and thus, it is possible to prevent an insulation problem from occurring due to being vulnerable to moisture.

Meanwhile, during the conductive pattern formation operation, the other surface of the film 110 and the second guide roller 72 are in contact with each other, and the second guide roller 72 may guide the movement of the film 110. Here, the second guide roller 72 may face the conductive pattern roller 30 with the film 110 therebetween.

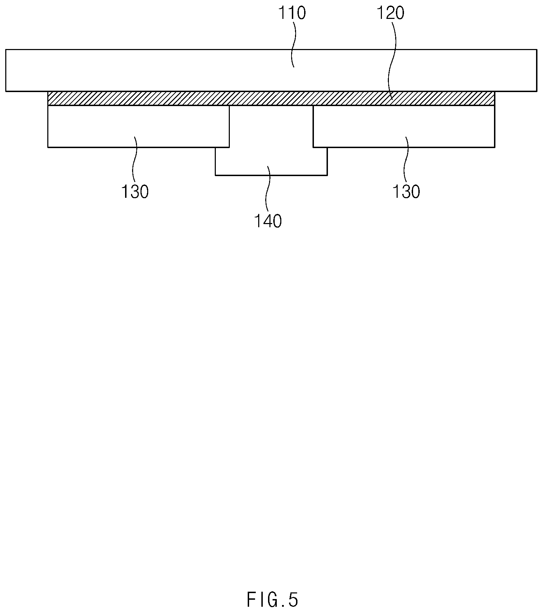

FIG. 5 is a cross-sectional view showing an operation of forming a temperature element in a method for manufacturing a printed circuit board for a battery pack capable of measuring temperature according to an embodiment of the present invention.

Referring to FIGS. 4 and 5, during the temperature element formation operation, the temperature element 140, which measures the temperature inside the battery pack 1000, may be formed on the second portion of the film 110 after the conductive pattern 130 is formed. Here, during the temperature element formation operation, the temperature element 140 may be positioned on the second portion of the one surface of the film 110.

Also, during the temperature element formation operation, the temperature element 140 may be printed on the film 110 with temperature element ink.

In addition, the temperature element may include a thermistor. Here, the temperature element may include a nickel oxide (NiO) material.

Also, during the temperature element formation operation, nickel oxide (NiO) ink accommodated in a temperature element pool 60 may be applied, through printing, on the second portion of the one surface of the film 110 by a temperature element roller 50. Here, during the temperature element formation operation, the nickel oxide (NiO) ink may be applied through printing, by the temperature element roller 50, on the second portion of the one surface of the film 110 that has been coated with the binder 120.

The temperature element roller 50 may have, as a roll-type print frame, a pattern frame that is formed along the outer circumferential surface and corresponds to the pattern of the temperature element 140.

Therefore, during the temperature element formation operation, the pattern of the temperature element 140 may be directly nano-printed on the film 110 by the temperature element roller 50 using the nickel oxide (NiO) ink. Accordingly, the pattern of the temperature element 140 does not protrude, and thus, it is possible to prevent a structural problem due to the protrusion. In addition, a surface mounted technology (SMT) process for structurally mounting the temperature element 140 is not used, and thus, manufacturing may be facilitated. Furthermore, the temperature element 140 includes the nickel oxide (NiO), which is easy to measure temperature, and thus, the temperature inside the battery pack 1000 may be easily and accurately measured.

Meanwhile, during the temperature element formation operation, the other surface of the film 110 and the third guide roller 73 are in contact with each other, and the third guide roller 73 may guide the movement of the film 110. Here, the third guide roller 73 may face the temperature element roller 50 with the film 110 therebetween.

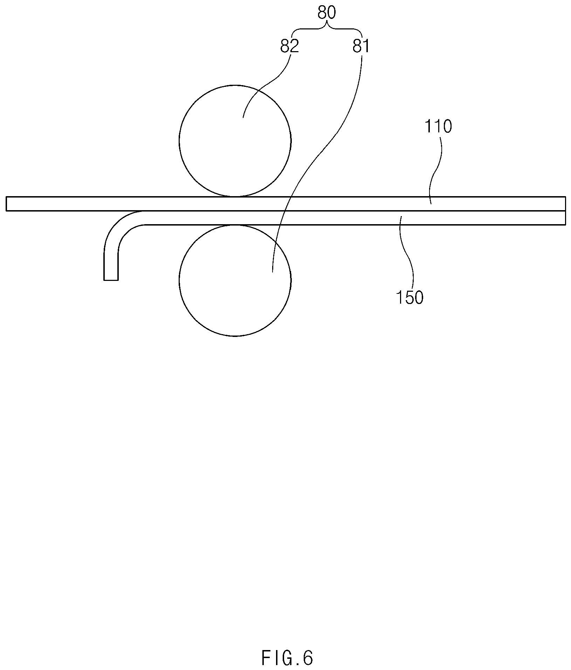

FIG. 6 is a front view showing an operation of forming a cover layer in a method for manufacturing a printed circuit board for a battery pack capable of measuring temperature according to an embodiment of the present invention.

Referring to FIGS. 1, 4, and 6, the cover layer formation operation is performed after the temperature element formation operation, and a cover layer 150 for covering both the conductive pattern 130 and the temperature element 140 may be formed.

Here, during the cover layer formation operation, the cover layer 150 may be positioned on one surface of the film 110 and applied to both the conductive pattern 130 and the temperature element 140 printed on the one surface of the film 110.

The cover layer 150 may include an insulating material. Also, the cover layer 150 may include, for example, resin.

In addition, during the cover layer formation operation, the cover layer 150 may be formed by laminating a cover sheet on one surface of the film 110 by a lamination roller 80.

The lamination roller 80 may include an upper lamination roller 81 and a lower lamination roller 82. Here, during the cover layer formation operation, the cover sheet and the film 110, on which the conductive pattern 130 and the temperature element 140 are printed, are allowed to pass between the upper lamination roller 81 and the lower lamination roller 82 and may be bonded to each other by applying heat and pressure thereto.

Although the present invention has been described in detail through the specific embodiments, these are intended to specifically describe the present invention, and the present invention is not limited thereto. Various modifications can be made within the technical idea of the present invention by those skilled in the art.

Also, the specific protection scope of the invention can become apparent from the appended claims.

### [Description of the Symbols]

- 10:: Binder roller
- 20:: Binder pool
- 30:: Conductive pattern roller
- 40:: Conductive pattern pool
- 50:: Temperature element roller
- 60:: Temperature element pool
- 70:: Guide roller
- 71:: First guide roller
- 72:: Second guide roller
- 73:: Third guide roller
- 80:: Lamination roller
- 81:: Upper lamination roller
- 82:: Lower lamination roller
- 100:: Printed circuit board
- 110:: Film
- 120:: Binder
- 130:: Conductive pattern
- 140:: Temperature element
- 150:: Cover layer
- 200:: Cell stack
- 210:: Secondary battery
- 211:: Electrode lead
- 300:: Pack case
- 400, 500:: Busbar frame
- 600, 700:: End plate
- 1000:: Battery pack

## Claims

1. A printed circuit board for a battery pack, capable of measuring temperature and provided in a battery pack that comprises a plurality of secondary batteries, the printed circuit board comprising:
a film;
a conductive pattern provided on a first portion of the film; and
a temperature element provided on a second portion of the film and measuring the temperature inside the battery pack.

2. The printed circuit board of claim 1, wherein the conductive pattern is positioned on the first portion of one surface of the film, and
the temperature element is positioned on the second portion of the one surface of the film.

3. The printed circuit board of claim 1 or 2, further comprising a cover layer configured to cover the conductive pattern and the temperature element.

4. The printed circuit board of claim 1, wherein the conductive pattern comprises a silver (Ag) material.

5. The printed circuit board of claim 1, wherein the temperature element comprises a thermistor.

6. The printed circuit board of claim 5, wherein the conductive pattern comprises an ink-type material, and the temperature element comprises an ink-type thermistor, and thus, the conductive pattern and the temperature element are provided in the form printed on the film.

7. The printed circuit board of claim 6, wherein the temperature element comprises a nickel oxide (NiO) material.

8. The printed circuit board of claim 1, further comprising a binder configured to bond the conductive pattern and the temperature element to the film.

9. A method for manufacturing a printed circuit board, which is provided in a battery pack that comprises a plurality of secondary batteries, the method comprising:
a film preparation operation of preparing a film;
a conductive pattern formation operation of forming a conductive pattern on a first portion of the prepared film; and
a temperature element formation operation of forming a temperature element, which measures the temperature inside the battery pack, on a second portion of the film after the conductive pattern is formed.

10. The method of claim 9, wherein the conductive pattern is positioned on the first portion of one surface of the film during the conductive pattern formation operation, and
the temperature element is positioned on the second portion of the one surface of the film during the temperature element formation operation.

11. The method of claim 9, further comprising, after the temperature element formation operation, a cover layer formation operation of forming a cover layer configured to cover the conductive pattern and the temperature element.

12. The method of claim 9, wherein the conductive pattern is printed on the film with conductive pattern ink during the conductive pattern formation operation, and
the temperature element is printed on the film with temperature element ink during the temperature element formation operation.

13. The method of claim 9, wherein the conductive pattern comprises a silver (Ag) material.

14. The method of claim 9, wherein the temperature element comprises a nickel oxide (NiO) material.

15. The method of claim 9, further comprising, after the film preparation operation and before the conductive pattern formation operation, a binder coating operation of coating the film with a binder configured to bond the conductive pattern and the temperature element to the film.
